# EUROPÄISCHE PATENTANMELDUNG

(11) **EP 2 184 623 A2**
(43) Veröffentlichungstag der Anmeldung: **12.05.2010**
(21) Anmeldenummer: 09013973.4
(22) Anmeldetag: 06.11.2009
(51) Int. Cl.: G01V 3/08

(54) **Sensorvorrichtung zum Detektieren eines Gegenstandes und dessen Bewegung in einem Messbereich der Sensorvorrichtung**

(30) Priorität: 06.11.2008 DE 102008056092
(71) Anmelder: Klaschka GmbH & Co. KG, 75233 Tiefenbronn-Lehningen (DE)
(72) Erfinder: Klaschka, Walter, 75233 Tieffenbronn-Lehningen (DE)
(74) Vertreter: Rasch, Michael

(57) **Zusammenfassung**

Sensorvorrichtung (1) zum Detektieren eines Gegenstandes und dessen Bewegung im Messbereich der Sensorvorrichtung (1), aufweisend ein um eine Gehäuseachse drehsymmetrisches oder einen polygonförmigen Querschnitt aufweisendes Gehäuse mit einer koaxial zur Gehäuseachse angeordneten Gehäuseöffnung, eine Sensorspule, die auf einer Vorderseite eines isolierenden ebenen Trägers aufgebracht und als Flachspule in einer Spulenebene ausgebildet ist, wobei die Sensorspule eine Anzahl n = 2 + i*2, mit i = 0, 1, 2,... drehsymmetrisch um eine zur Spulenebene senkrechte Spulenachse z angeordnete, sich nicht überlappende Spulensektionen aufweist, die eine identische Windungszahl und einen identischen Wickelsinn besitzen, und der Träger mit der Sensorspule derart in die Gehäuseöffnung eingebracht ist, dass die Trägervorderseite und damit die Sensorspule in der Gehäuseöffnung gehäuseoberflächennah angeordnet ist, eine mit der Sensorspule elektrisch verbundene Sensorelektronik, und eine mit der Sensorelektronik verbindbare elektrische Energiequelle, wobei mittels der Sensorspule ein magnetisches Wechselfeld erzeugbar ist, welches mit im Messfeld der Sensorvorrichtung (1) befindlichen oder sich bewegenden Gegenständen wechselwirkt und aufgrund der Wechselwirkung Änderungen von Kenngrößen (L, C, R) der Sensorspule bewirkt, die mittels der Sensorelektronik detektierbar sind.

## Beschreibung

Die Erfindung betrifft eine Sensorvorrichtung zum Detektieren eines Gegenstandes und dessen Bewegung in einem Messbereich der Sensorvorrichtung, die ein Gehäuse, eine Sensorspule, eine mit der Sensorspule elektrisch verbundene Sensorelektronik sowie eine mit der Sensorelektronik verbindbare elektrische Energiequelle aufweist.

Sensorvorrichtungen zum Detektieren eines Gegenstandes sind bekannt. Sie können dazu eingesetzt werden, eine Annäherung oder eine in Gegenwart des Gegenstandes, der insbesondere ein Metall aufweisen kann, berührungslos zu erkennen und dazu ein Signal zu generieren. Das Signal kann beispielsweise als elektrisches Signal zur Weiterleitung und/oder als optisches Signal für ein direktes Erkennen ausgenutzt werden. Mittels der Spule der Sensorvorrichtung kann ein hochfrequentes Magnetfeld erzeugt werden, dessen Feldstärke in der näheren Umgebung der Spule eine für eine Detektion des Gegenstandes nutzbare Größe erreicht. Falls der insbesondere ein elektrisch leitfähiges Material aufweisende Gegenstand in das hinreichend starke Wechselfeld eindringt, induziert das hochfrequente Wechselfeld in dem Gegenstand hochfrequente elektrische Ströme, was mit einer erhöhten Verlustleistung in der Spule und damit mit einer signifikanten Änderung von zumindest einer Kenngröße der Spule einhergeht. Zumindest einer der Kenngrößen kann mittels der Sensorelektronik ausgewertet werden. Die DE 94 12 765 U1 zeigt einen induktiven Näherungssensor zur materialunabhängigen Abstandsmessung. Aus der US 5 245 307 A ist eine Suchspulenanordnung mit einer auf einem Sende-/Empfangsprinzip beruhenden induktiven Suchvorrichtung bekannt. Es sind eine Sende- und eine Empfangsspule vorgesehen.

Aufgabe der Erfindung ist es, eine verbesserte Sensorvorrichtung zum Detektieren eines Gegenstandes und dessen Bewegung im Messbereich der Sensorvorrichtung bereitzustellen, insbesondere eine größtmögliche Genauigkeit und/oder Unabhängigkeit von Umgebungseinflüssen zu ermöglichen.

Die Aufgabe ist bei einer Sensorvorrichtung zum Detektieren eines Gegenstandes und dessen Bewegung in einem Messbereich der Sensorvorrichtung, aufweisend ein um eine Gehäuseachse drehsymmetrisches oder einen polygonförmigen Querschnitt aufweisendes Gehäuse mit einer koaxial zur Gehäuseachse angeordneten Gehäuseöffnung, eine Sensorspule, die auf einer Vorderseite eines isolierenden ebenen Trägers aufgebracht und als Flachspule in einer Spulenebene ausgebildet ist, wobei die Sensorspule eine Anzahl n = 2 + i*2, mit i = 0, 1, 2,... drehsymmetrisch um eine zur Spulenebene senkrechte Spulenachse z angeordnete, sich nicht überlappende Spulensektionen aufweist, die eine identische Windungszahl und einen identischen Wickelsinn besitzen, und der Träger mit der Sensorspule derart in die Gehäuseöffnung eingebracht ist, dass die Trägervorderseite und damit die Sensorspule in der Gehäuseöffnung gehäuseoberflächennah angeordnet ist, eine mit der Sensorspule elektrisch verbundene Sensorelektronik, und eine mit der Sensorelektronik verbindbare elektrische Energiequelle, wobei mittels der Sensorspule ein magnetisches Wechselfeld erzeugbar ist, welches mit im Messfeld der Sensorvorrichtung befindlichen oder sich bewegenden Gegenständen wechselwirkt und aufgrund der Wechselwirkung Änderungen von Kenngrößen (L, C, R) der Sensorspule bewirkt, die mittels der Sensorelektronik detektierbar sind gelöst. Vorteilhaft weist die Sensorspule eine gerade Anzahl von drehsymmetrisch zueinander angeordneten Spulensektionen auf, die eine identische Windungszahl und einen identischen Wicklungssinn besitzen. Unter drehsymmetrisch kann eine deckungsgleiche Abbildung der Sensorspule auf sich selbst mittels einer Drehung um eine senkrecht zu einer flächigen Ausdehnung der Sensorspule und zentrisch zu der Sensorspule angeordnete z-Achse um 360° dividiert durch eine Zahl n = 2 + i * 2, mit i = 0, 1, 2,... insbesondere die Anzahl der Spulensektionen, verstanden werden. Die zentrisch angeordnete z-Achse kann vorteilhaft identisch mit der Gehäuseachse sein. Vorteilhaft ergibt sich ein insgesamt drehsymmetrischer Aufbau bezüglich der z-Achse des drehsymmetrischen Gehäuses und der Sensorspule. Das Gehäuse kann insbesondere als Rotationskörper, beispielsweise als Hohlzylinder, oder als Polygonkörper ausgebildet sein. Die Sensorspule ist senkrecht zur mit der Spulenachse z zusammenfallenden Gehäuseachse des drehsymmetrischen Gehäuses angeordnet. Bei einer Bestromung der Sensorspule kann jede Sektion ein eigenes Wechselfeld erzeugen, das gegebenenfalls in sich in diesen befindenden metallischen Gegenständen Wechselströme induziert. Sofern es sich bei dem Gehäuse um ein Metallgehäuse handelt, können dadurch im Grundsatz unerwünschte Ringströme in einer um die Gehäuseachse, beispielsweise kreisförmig, umlaufenden Gehäusewand induziert werden. Es wurde erkannt, dass bei einer gegensinnigen Bestromung der gleichsinnig gewickelten Spulensektionen der Sensorspule die Ringströme in der Gehäusewand derart induziert werden, dass sich diese gegenseitig aufheben. Die gegensinnige Bestromung kann durch eine einfache elektrische Verbindung der Spulensektionen erfolgen, sodass beide Spulensektionen von identischen Strömen durchflossen werden. Die Verbindung kann vorteilhaft so ausgeführt werden, dass dadurch keine Störung der Symmetrie erfolgt. Insbesondere gehen Enden der Spulensektionen leitend miteinander verbunden ineinander über, wobei die verbundenen Spulensektionen eine einzige Gesamtspule bilden. Diese Gesamtspule weist eine einuige durchgehende Leiterbahn auf, die die Drehsymmetrie aufweist. Gegebenenfalls kann die Leiterbahn unterschiedliche Ausbildungen, wie Dicken, Knicke, Krümmungen, etc. aufweisen, solange diese ebenfalls drehsymmetrisch ausgebildet sind. Die einzige Leiterbahn weist zwei Anschlüsse auf, wobei die gesamte Leiterbahn, also beide Spulensektionen von einem gesamten Strom durchflossen werden. Ferner wurde erkannt, dass dadurch eine auf eine Ebene abgebildete Kreisringspule beziehungsweise Toroidspule gebildet wird. Vorteilhaft ähnelt das erzeugbare Wechselfeld dem einer Kreisringspule beziehungsweise Toroidspule. Vorteilhaft werden trotz der ebenen Anordnung der Sensorspule die von Kreisringspulen beziehungsweise Toroidspulen bekannten Vorteile erzielt, wobei sich das erzeugbare Wechselfeld nicht oder zumindest nur minimal über die Dimensionen einer x- und y-Richtung der Sensorspule nach außen ausbreitet, also die gewünschte nicht vorhandene oder zumindest nur minimale Wechselwirkung mit dem Gehäuse erzielbar ist. Das erzeugbare Wechselfeld breitet sich vorteilhaft hauptsächlich in Richtung der z-Achse, also in einer Messrichtung aus. Aufgrund der geraden Anzahl von Spulensektionen ist es möglich, die Wicklungen so zu bestromen, dass jeweils gleiche Anzahlen sich gegenseitig aufhebender Ströme in dem Gehäuse induziert werden. Bei mehr als zwei Spulensektionen ist es möglich, jeweils benachbarte Spulensektionen gegensinnig zu bestromen. Es ist jedoch auch möglich, die Spulensektionen beliebig zu bestromen, solange gewährleistet ist, dass jeweils die eine Hälfte in einer ersten Richtung und die andere Hälfte in einer zweiten Richtung bestromt wird. Unter Gehäuseöffnung kann ein beliebiger Durchbruch, insbesondere kreisförmig, beispielsweise als Bohrung, jedoch auch ein vorgesehenes Material, das mit dem Wechselfeld nicht oder zumindest nur minimal wechselwirkt, verstanden werden. Unter koaxial kann verstanden werden, dass eine gedachte Fläche zum Schließen der Gehäuseöffnung zumindest ungefähr senkrecht zur Gehäuseachse steht. Alternativ und/oder zusätzlich kann verstanden werden, dass ein Flächenschwerpunkt der gedachten Fläche mit der Gehäuseachse zusammenfällt. Unter oberflächennah kann eine Anordnung direkt benachbart zu beziehungsweise direkt unterhalb einer Abdeckung, die einen Teil einer Gehäuseoberfläche aufweist verstanden werden. Es kann jedoch auch darunter verstanden werden, dass die Trägervorderseite die Gehäuseöffnung verschließt und selbst eine Oberfläche des Gehäuses bildet, z.B. auf einem Niveau einer gedachten, die Gehäuseöffnung verschließenden Bespannung beziehungsweise Seifenhaut angeordnet ist.

Bei einem Ausführungsbeispiel der Sensorvorrichtung ist vorgesehen, dass die Sensorelektronik auf einer der Trägervorderseite gegenüberliegenden Trägerrückseite angeordnet ist, wobei die Anordnung der die Sensorelektronik umfassenden Bauelemente auf der Trägerrückseite drehsymmetrisch zur Spulenachse ist. Mittels den drehsymmetrisch zueinander angeordneten Sektionen der Sensorspule kann ein daraus folgend drehsymmetrisches Wechselfeld aufgebaut werden. Da sich die Sensorelektronik in einem signifikanten Bereich des erzeugbaren Wechselfeldes befindet, ist davon auszugehen, dass dadurch eine Wechselwirkung mit und/oder eine Beeinflussung des erzeugbaren Wechselfeldes stattfindet. Vorteilhaft kann mittels der ebenfalls drehsymmetrischen Anordnung der Sensorelektronik zwar nicht die Beeinflussung des Wechselfeldes verhindert werden, jedoch sichergestellt werden, dass trotz dieser die Drehsymmetrie des erzeugbaren Wechselfeldes erhalten bleibt. Vorteilhaft kann dadurch auch sichergestellt werden, dass sich die in dem Gehäuse induzierten Ringströme trotz der Anordnung der Sensorelektronik aufheben. Unter nicht überlappend kann eine kreuzungsfreie Anordnung von Leiterbahnen beziehungsweise der Wicklung der Sensorspule beziehungsweise der Wicklungen der Spulensektionen verstanden werden.

Bei einem weiteren Ausführungsbeispiel der Sensorvorrichtung ist vorgesehen, dass Enden der Sensorspule mit der Sensorelektronik durch drehsymmetrisch zur Spulenachse angeordnete Bohrungen im Träger kontaktiert sind. Auch Kontaktierungen und Bohrungen innerhalb des Trägers können den Aufbau des mittels der Sensorspule erzeugbaren magnetischen Wechselfeldes beeinflussen. Da auch diese drehsymmetrisch zur z-Achse angeordnet sind, ist ebenfalls keine Störung der Drehsymmetrie des magnetischen Wechselfeldes und damit der Auslöschung der Ringströme in dem Gehäuse zu erwarten.

Bei einem weiteren Ausführungsbeispiel der Sensorvorrichtung ist vorgesehen, dass die Sensorelektronik axial zur Spulenachse und/oder auf dem Träger angeordnet ist. Vorteilhaft kann durch die axiale Anordnung der Sensorelektronik eine minimale Beeinflussung des magnetischen Wechselfeldes gewährleistet werden, wobei sich dadurch ebenfalls ein quasi drehsymmetrischer Aufbau ergibt. Außerdem befindet sich dann die Sensorelektronik in einem Bereich, der aufgrund der gegensinnigen Bestromung der Sektionen der Sensorspule ein Minimum an magnetischen Feldlinien enthält, wobei auch ein Minimum an Wechselwirkungen zu erwarten ist.

Bei einem weiteren Ausführungsbeispiel der Sensorvorrichtung ist vorgesehen, dass der Träger aus Kunststoff oder Keramik besteht und eine geringe Dicke, insbesondere 0,01 bis 1 mm, insbesondere 0,05 bis 2 mm, insbesondere 0,1 bis 0,9 mm, insbesondere aufweist.
Vorteilhaft ist ein möglichst kompakter Aufbau der Sensorvorrichtung möglich.

Bei einem weiteren Ausführungsbeispiel der Sensorvorrichtung ist vorgesehen, dass die Sensorspule 2, 4 oder 6 drehsymmetrische Spulensektionen aufweist, die Paare bilden, wobei jedes Paar zwei Kontakte aufweist und einen mittels den Kontakten bestombaren gemeinsamen Leiter aufweist. Vorteilhaft können jeweils eine, jeweils zwei oder jeweils drei Spulensektionen gegensinnig zueinander bestromt werden, was vorteilhaft zu der Aufhebung der in dem Gehäuse induzierten Ringströme führt. Durch einfaches Kontaktieren der Kontakte des jeweiligen Paars ist bereits sichergestellt, dass die drehsymmetrischen Spulensektionen in Reihe geschaltet sind und daher von einem gemeinsamen Strom durchflossen werden. Die Spulensektionen wirken wie eine einzige Gesamtspule, die vorteilhaft ein Feld ausbildet, das dem einer Toroidspule gleicht oder zumindest ähnlich ist.

Bei einem weiteren Ausführungsbeispiel der Sensorvorrichtung ist vorgesehen, dass im Fall von zwei Spulensektionen im drehsymmetrischen Mittelpunkt der Sensorspule ein elektrischer Abgriff (C) vorgesehen ist. Im Fall von zwei Spulensektionen kann im drehsymmetrischen Mittelpunkt der Sensorspule der elektrische Abgriff (C) vorgesehen sein. Vorteilhaft kann mittels des auf der z-Achse angeordneten elektrischen Abgriffs eine Aufteilung der Sensorspule in exakt zwei gleiche Spulensektionen erreicht werden. Mittels des Abgriffs können die einzelnen Sektionen separat beobachtet und/oder bestromt werden.

Bei einem weiteren Ausführungsbeispiel der Sensorvorrichtung ist vorgesehen, dass die Sensorelektronik an den Enden (A, B) der Sensorspule angeschlossene, eine oder mehrere Kapazitäten aufweist, die mit der Eigenkapazität der Sensorspule einen Resonanzkreis beziehungsweise Schwingkreis bilden. Vorteilhaft kann mittels des gebildeten Schwingkreises das elektrische Wechselfeld erzeugt werden. Der Schwingkreis kann beispielsweise als Parallelschwingkreis oder als Reihenschwingkreis ausgebildet sein.

Bei einem weiteren Ausführungsbeispiel der Sensorvorrichtung ist vorgesehen, dass die Sensorelektronik einen Oszillator umfasst, wobei der Schwingkreis Bestandteil des Oszillators ist, und der Oszillator mit einer Frequenz betreibbar ist, die der Eigenfrequenz des Schwingkreises entspricht. Vorteilhaft kann mittels des Oszillators der Resonanzkreis beziehungsweise Schwingkreis auf seiner Eigenfrequenz betrieben werden. Im Falle einer Annäherung des Gegenstandes, kann der Schwingkreis vorteilhaft seine Frequenz an die dadurch geänderte Eigenfrequenz anpassen, was vorteilhaft für eine Messung ausnutzbar ist. Da der Oszillator Teil des Schwingkreises ist, ergibt sich ein besonders einfacher und eine geringe Menge an Bauteilen umfassender Oszillator. Vorteilhaft ist aufgrund des einfachen Aufbaus des Oszillators auch eine möglichst geringe Beeinflussung des mittels der Sensorspule erzeugbaren magnetischen Wechselfeldes zu erwarten.

Bei einem weiteren Ausführungsbeispiel der Sensorvorrichtung ist vorgesehen, dass die Sensorelektronik einen Festfrequenz-Oszillator umfasst, wobei der Schwingkreis von dem Festfrequenz-Oszillator fremd erregbar ist, und die Frequenz des Festfrequenz-Oszillators mit der Eigenfrequenz des Schwingkreises solange identisch ist, solange sich im Messbereich der Sensorvorrichtung kein Gegenstand befindet. Vorteilhaft ist für eine Erregung des Schwingkreises mittels einer Eigenfrequenz eine minimale Menge an Hilfsenergie zum Erhalten der Schwingung notwendig. Vorteilhaft kann eine Annäherung des Gegenstandes besonders gut mittels einer Phasenverschiebung detektiert werden. Vorteilhaft tritt im Bereich der Eigenfrequenz bei einer Fremderregung eine Phasenverschiebung des Stromes i bei der Spannung u auf, die vorteilhaft zum Detektieren der Annäherung des Gegenstandes ausgenutzt werden kann.

Bei einem weiteren Ausführungsbeispiel der Sensorvorrichtung ist vorgesehen, dass die Sensorelektronik an den Enden (A, B) und am Abgriff (C) der Sensorspule jeweils angeschlossene, ein oder mehrere Kapazitäten aufweist, die mit den Eigenkapazitäten der jeweiligen Spulensektionen jeweils einen Resonanzkreis beziehungsweise Schwingkreis bilden. Vorteilhaft kann pro Spulensektion ein eigener Schwingkreis betrieben werden. Dies kann vorteilhaft zum Ermitteln einer Position des Gegenstandes relativ zu den einzelnen Spulensektionen bzw. zur Sensorspule ausgenutzt werden. Vorteilhaft weist der Gegenstand zu den einzelnen Spulensektionen der Sensorspule einen unterschiedlichen Winkel und Abstand auf, so dass unterschiedliche Wechselwirkungen mit den jeweils zugehörigen Schwingkreisen auftreten, die wiederum vorteilhaft für die Positionsbestimmung des Gegenstandes gedeutet werden können.

Bei einem weiteren Ausführungsbeispiel der Sensorvorrichtung ist vorgesehen, dass die Sensorelektronik einen Festfrequenz-Oszillator umfasst, wobei jeder Schwingkreis von dem Festfrequenz-Oszillator fremd erregbar ist, und die Frequenz des Festfrequenz-Oszillators mit den untereinander übereinstimmenden Eigenfrequenzen der Schwingkreise solange identisch ist, solange sich im Messbereich der Sensorvorrichtung kein Gegenstand befindet. Die Auswertung der einzelnen Spulensektionen kann jeweils mittels der Festfrequenz erregten einzelnen Schwingkreise wie vorab beschrieben erfolgen.

Bei einem weiteren Ausführungsbeispiel der Sensorvorrichtung ist vorgesehen, dass die Sensorelektronik eine Temperaturkompensation durch zwei oder mehr Kondensatoren beziehungsweise Kapazitäten mit einem unterschiedlichen Temperaturverhalten umfasst. Vorteilhaft kann die Sensorvorrichtung trotz möglicherweise auftretender Temperaturunterschiede den Gegenstand exakt detektieren.

Bei einem weiteren Ausführungsbeispiel der Sensorvorrichtung ist vorgesehen, dass die Sensorvorrichtung einer Montageplatte zugeordnet ist, wobei die Montageplatte eine flache Grundform mit einer Oberfläche aufweist, wobei die Gehäuseachse und die z-Achse senkrecht zu der Oberfläche angeordnet sind. Die Montageplatte kann ebenfalls ein elektrisch leitfähiges Material, beispielsweise ein Metall, aufweisen. Aufgrund der senkrechten Anordnung wird die Drehsymmetrie des magnetischen Wechselfeldes nicht oder nur minimal gestört, so dass vorteilhaft aufgrund der senkrechten Anordnung keine oder zumindest nur eine minimale negative Beeinflussung eines Messergebnisses der Sensorvorrichtung zu erwarten ist.

Bei einem weiteren Ausführungsbeispiel der Sensorvorrichtung ist vorgesehen, dass das Gehäuse einen rechteckigen Querschnitt aufweist. Vorteilhaft sind Rechtecke bezüglich Drehungen um 180° um einen Flächenschwerpunkt drehsymmetrisch. Unter einem rechteckigen Querschnitt kann beispielsweise auch ein quadratischer Querschnitt verstanden werden, der bezüglich Drehungen um 90° drehsymmetrisch ist. Auch konische Grundformen des Gehäuses sind denkbar.

Bei einem weiteren Ausführungsbeispiel der Sensorvorrichtung ist vorgesehen, dass der Träger mit der Sensorspule derart in die Gehäuseöffnung eingebracht ist, dass die Gehäuseachse und die Spulenachse z zusammenfallen. Vorteilhaft ergibt sich ein insgesamt drehsymmetrischer Aufbau.

Bei einem weiteren Ausführungsbeispiel der Sensorvorrichtung ist vorgesehen, dass die Sensorspule und eine weitere identisch aufgebaute Sensorspule vorgesehen sind, die drehsymmetrisch zur Gehäuseachse angeordnet sind. Vorteilhaft können zwei separate Sensorsignale generiert werden, wobei vorteilhaft dennoch ein drehsymmetrischer Aufbau gegeben ist.

Bei einem weiteren Ausführungsbeispiel der Sensorvorrichtung ist vorgesehen, dass der Gegenstand ein Zahnrad mit einem Zahnabstand aufweist, wobei die Spulenachsen z der Sensorspulen einen Abstand aufweisen, der ungefähr das (0,25 + n*0,5)-fache des Zahnabstands mit n = 0, 1, 2, 3 ... beträgt. Vorteilhaft kann das Zahnrad abgetastet werden, insbesondere mit einer mittels der Phasenverschiebung darstellbaren Drehrichtungserkennung.

Bei einem weiteren Ausführungsbeispiel der Sensorvorrichtung ist vorgesehen, dass beabstandet zu der in dem Gehäuse angeordneten Sensorspule eine in einem zusätzlichen vorab beschriebenen Gehäuse angeordnete zusätzliche vorab beschriebene Sensorspule angeordnet ist. Vorteilhaft kann der Gegenstand doppelt abgetastet werden, wobei vorteilhaft zusätzliche Informationen, beispielsweise über eine Kontur und/oder eine Relativgeschwindigkeit des Gegenstandes zur Sensorvorrichtung und/oder eine Richtungserkennung gewinnbar sind. Die Sensorspulen und Gehäuse sind vorzugsweise identisch aufgebaut und können jeweils eine eigene Auswerteelektronik aufweisen. Es ist jedoch auch denkbar, dass die Sensorspulen und die jeweiligen Gehäuse zwar grundsätzlich jeweils gemäß einem der vorab beschriebenen Ausführungsbeispiele aufgebaut sind, jedoch unterschiedlich ausgeführt sind. Vorteilhaft können die Sensorspulen ohne oder zumindest mit einer nur minimalen gegenseitigen Beeinflussung nebeneinander angeordnet werden, da die mittels der Sensorspulen erzeugbaren Felder sich vorteilhaft nur oder quasi nur in einer z-Richtung beziehungsweise Messrichtung der jeweiligen Sensorspule ausbreiten.

Bei einem weiteren Ausführungsbeispiel der Sensorvorrichtung ist vorgesehen, dass den Sensorspulen eine Auswerteeinheit nachgeschaltet ist, mittels der ein erstes Sensorsignal der ersten Sensorspule und ein weiteres Signal der zusätzlichen Sensorspule vergleichbar und/oder auswertbar sind. Vorteilhaft kann die zusätzliche Information mittels der Auswerteeinheit gewonnen und/oder aufbereitet werden.

Die Aufgabe ist außerdem bei einem Verfahren zum Detektieren eines Gegenstandes und dessen Bewegung in einem Messbereich einer Sensorvorrichtung, insbesondere einer vorab beschreibenen Sensorvorrichtung, mit einer Sensorspule, die eine Anzahl n = 2 + i*2, mit i = 0, 1, 2,... auf einer zu einer Spulenachse z senkrechten Spulenebene paarweise gegenüberliegend oder drehsymmetrisch zur Spulenachse z angeordnete, sich nicht überlappende Spulensektionen aufweist, und mit einer in einem Abstand zu der Sensorspule angeordneten zusätzlichen Sensorspule, die eine Anzahl n = 2 + i*2, mit i = 0, 1, 2,... auf einer zu einer Spulenachse z senkrechten Spulenebene paarweise gegenüberliegend oder drehsymmetrisch zur Spulenachse z angeordnete, sich nicht überlappende Spulensektionen aufweist, mit jeweils paarweise gegensinniges Bestromen der Spulensektionen der Sensorspule und der zusätzlichen Sensorspule und Detektieren von Änderungen von Kenngrößen (L, C, R) der Sensorspule und der weiteren Sensorspule mittels einer den Sensorspulen zugeordneten Auswerteeinheit gelöst. Neben vorab beschriebenen Vorteilen der Sensorvorrichtung ist es aufgrund des jeweiligen gegensinnigen Bestromens möglich, mehrere der Sensorspulen wechselwirkungsfrei oder zumindest wechselwirkungsminimal nebeneinander anzuordnen. Vorteilhaft können die Sensorspulen dicht nebeneinander angeordnet werden, insbesondere direkt nebeneinander, insbesondere in einem Abstand von weniger als einer 0,5-fachen, insbesondere 1,0-fachen, insbesondere 2-fachen, insbesondere 5-fachen Breite beziehungsweise eines Durchmessers einer der Sensorspulen. Mittels der Auswerteeinheit können zusätzliche Informationen über den Gegenstand gewonnen und/oder aufbereitet werden.

Bei einer Ausführungsform des Verfahrens sind ein Bewegen des Gegenstands oder eine Vielzahl der Gegenstände mit einer Relativgeschwindigkeit relativ zu der Sensorvorrichtung, ein Ermitteln eines Verlaufs oder einer Charakteristik der detektierten Änderungen von Kenngrößen (L, C, R) der Sensorspule, ein Ermitteln eines Verlaufs oder einer Charakteristik der detektierten Änderungen von Kenngrößen (L, C, R) der weiteren Sensorspule, ein Zuordnen des Verlaufs oder der Charakteristik der Sensorspule zu dem Verlauf oder der Charakteristik der weiteren Sensorspule, ein Ermitteln eines Zeitversatzes zwischen den Verläufen oder den Charakteristiken, ein Ermitteln der Relativgeschwindigkeit mittels des Zeitversatzes und des Abstands der Sensorspulen und ein Ermitteln einer Kontur des Gegenstands oder eines Abstands einzelner Gegenstände der Vielzahl der Gegenstände aus dem Zeitversatz und der Relativgeschwindigkeit vorgesehen.
Unter Bewegungsrichtung kann beispielsweise eine Bewegung des Gegenstandes oder der Gegenstände senkrecht zu den Spulenachsen verstanden werden. Die Spulenachsen können beispielsweise parallel zueinander angeordnet sein, wobei vorteilhaft lineare Bewegungen des Gegenstandes oder der Gegenstände besonders gut gemessen werden können. Alternativ ist es möglich, dass die Spulenachsen in einem Winkel zueinander stehen, wobei gekrümmte Bahnen, insbesondere kreisförmige, des Gegenstands oder der Gegenstände besonders gut gemessen werden können. Vorteilhaft können die Sensorspulen dicht beieinander liegen ohne sich gegenseitig zu beeinflussen, da Felder der Sensorspulen sich vorteilhaft nicht überlagern. Vorteilhaft kann ein Abstand der Sensorspulen beziehungsweise deren Spulenachsen als bekannt vorausgesetzt werden, wobei aus einem Zeitversatz der einzelnen Sensorsignale vorteilhaft die Relativgeschwindigkeit berechenbar ist. Vorteilhaft können die Gegenstände vermessen werden.

Weitere Vorteile, Merkmale der Erfindung ergeben sich aus der nachfolgenden Beschreibung, in der unter Bezug auf die Zeichnung ein Ausführungsbeispiel im Einzelnen beschrieben ist. Gleiche, ähnliche und/oder funktionsgleiche Teile sind mit gleichen Bezugszeichen versehen. Es zeigen:
- Fig. 1: einen Längsschnitt einer Sensorvorrichtung mit einem drehsymmetrischen
Gehäuse, einer Sensorspule und einer
Sensorelektronik, die als Positionssensor beschaltet ist;
- Fig. 2: einen Längsschnitt einer weiteren Sensorvorrichtung, ähnlich der in Figur 1 gezeigten, jedoch als Näherungsschalter beschaltet;
- Fig. 3: einen Querschnitt einer Innenansicht einer weiteren Sensorvorrichtung auf eine Sensorelektronik;
- Fig. 4: eine schematische Ansicht einer planar Anordnung einer Sensorspule sowie
ein diese umgebendes Gehäuse mit einem rechteckigen Querschnitt;
- Fig. 5: eine weitere schematische Ansicht einer drehsymmetrisch aufgebauten Sensorspule, die von einem drehsymmetrisch aufgebauten Gehäuse umgeben ist;
- Fig. 6: verschiedene schematische Ansichten von drehsymmetrisch aufgebauten Sensorspulen, mit zwei, vier sowie sechs Spulensektionen;
- Fig. 7: eine schematisierte Seitenansicht einer Sensorvorrichtung sowie einer Montagevorrichtung, wobei die Sensorvorrichtung senkrecht zur Montagevorrichtung
angeordnet ist;
- Fig. 8: eine schematische Außenansicht einer weiteren Sensorvorrichtung mit zwei Sensorspulen, die analog der in Figur 4 dargestellten Sensorspule aufgebaut sind und von einem zylindrischen Gehäuse umgeben sind;
- Fig. 9: eine schematische Innenansicht der in Figur 8 gezeigten Sensorvorrichtung auf eine Sensorelektronik;
- Fig. 10: einen Längsschnitt der in den Figuren 8 und 9 dargestellten Sensorvorrichtung zusammen mit einem teilweise dargestellten Zahnrad;
- Fig. 11: eine schematische Ansicht einer Sesnorvorrichtung mit zwei Sensorspulen und einer Vielzahl von Gegenständen; und
- Fig. 12: ein Schaubild von zwei Sensorsignalen der in Fig. 11 gezeigten Sensorspulen über einer Zeitachse.

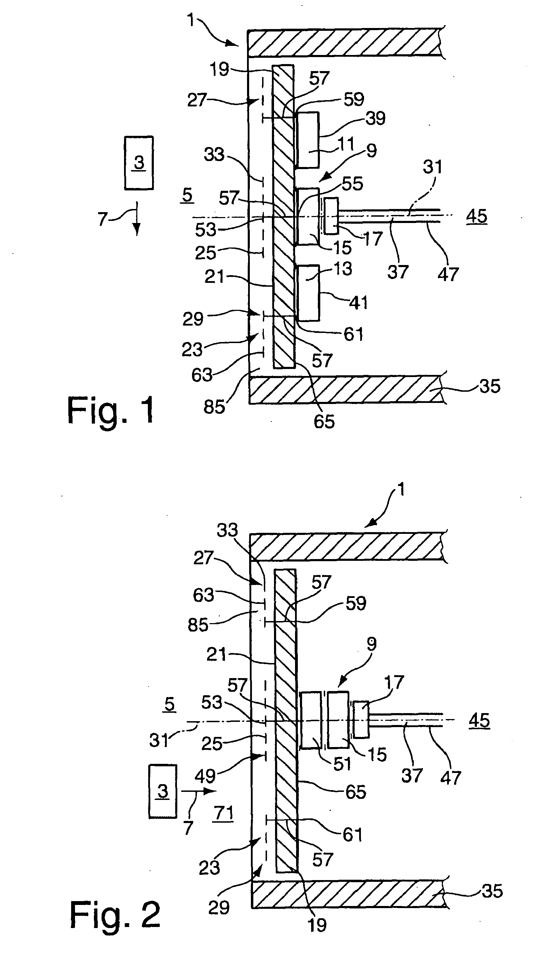

Figur 1 zeigt einen Längsschnitt einer Sensorvorrichtung 1 zum Detektieren eines Gegenstandes 3 und dessen Bewegung in einem mittels des Bezugszeichens 5 angedeuteten Messbereichs der Sensorvorrichtung 1. Die in Figur 1 gezeigte Sensorvorrichtung ist so beschaltet, dass sie eine Position und/oder eine Bewegung des Gegenstandes 3 in Richtung eines Pfeiles 7, oder umgekehrt, detektieren kann. Die Sensorvorrichtung 1 kann daher beispielsweise zum Auslesen von an dieser vorbeigeführten Zähnen eines Zahnrades verwendet werden.

Die Sensorvorrichtung 1 weist eine Sensorelektronik 9 mit einer ersten Kapazität 11, einer zweiten Kapazität 13, einem Oszillator 15 sowie einer optionalen Temperaturkompensation 17 auf. Die Temperaturkompensation 17 kann eine Kapazität mit einem speziell abgestimmten Temperaturverhalten aufweisen. Alternativ und/oder zusätzlich ist es möglich, eine Temperaturkompensation auch mittels der Kapazitäten 11 und 13 darzustellen, wobei diese dazu entsprechende Temperaturverhalten aufweisen können. Die Sensorelektronik 9 ist an einem scheibenförmigen Träger 19, beispielsweise ein keramisches Material aufweisend, insbesondere Aluminiumoxyd, befestigt. Der Träger 19 weist zum Beispiel als gedruckte Schaltung auf einer Trägervorderseite 21 eine Sensorspule 23 auf. Die Sensorspule 23 umfasst Windungen 25, die eine erste Spulensektion 27 und eine zweite Spulensektion 29 bilden. Die erste und die zweite Spulensektion 29 sind gleichsinnig gewickelt, weisen also einen identischen Wickelsinn auf und sind drehsymmetrisch zueinander bezüglich einer Spulenachse z 31 angeordnet. Die Sensorspule 23 ist flächig ausgebildet und weist eine Spulenebene 33 auf, in der die Windungen 25 der Sensorspule 23 angeordnet sind. Die Spulenebene 33 steht senkrecht zur Spulenachse z 31.

Die Sensorspule 23 bzw. der diese aufweisende Träger 19 sind von einem Gehäuse 35 umgeben. Das Gehäuse 35 ist bezüglich einer Gehäuseachse 37 drehsymmetrisch aufgebaut, weist beispielsweise eine zylindrische Grundform auf. Das Gehäuse 35 kann ein elektrisch leitfähiges Material aufweisen, beispielsweise ein Metall und/oder ein elektrisch leitfähiges Kunststoffmaterial. Die Gehäuseachse 35 und die Spulenachse 31 fallen zusammen, so dass die Spulensektionen 27, 29 der Sensorspule 23 und das Gehäuse 35 mittels einer Drehung um die gemeinsame Spulenachse z 31 bzw. Gehäuseachse 37 um 180° aufeinander abbildbar sind.

Zum Erzeugen eines hochfrequenten magnetischen Wechselfeldes weist die Sensorelektronik 9 einen ersten Schwingkreis 39 sowie einen zweiten Schwingkreis 41 auf, die mittels des Oszillators 15 so geschaltet sind, dass diese eine ungedämpfte Schwingung durchführen können. Die Schwingkreise 39 und 41 sind als Parallelschwingkreise ausgeführt. Alternativ oder Zusätzlich ist es auch denkbar diese als Reihenschwingkreise auszuführen. Der erste Schwingkreis 39 weist die erste Kapazität 11 sowie die erste Spulensektion 27 auf. Der Oszillator 15 kann so ausgelegt sein, dass die erste Spulensektion 27 bzw. eine Eigenkapazität der ersten Spulensektion 27 zusammen mit der ersten Kapazität 11 ein elektrisches schwingfähiges System bilden, das mittels des Oszillators 15 zu einer ungedämpften elektrischen Schwingung anregbar ist. Ebenso verhält es sich mit der zweiten Kapazität 13 und der zweiten Spulensektion 29. Es ist denkbar, dass es sich bei dem Oszillator 15 um einen Festfrequenzoszillator handelt, der die Schwingkreise 39 und 41 mit einer vorgegebenen festen Frequenz fremd erregt. Bei dieser festen Frequenz kann es sich vorteilhaft um die jeweilige Resonanzfrequenz, die vorliegend bei dem Schwingkreis 39 und 41 identisch ist, handeln, die diese aufweisen, wenn der Gegenstand 3 sich außerhalb des Messbereiches 5 befindet. Bei einem Hindurchführen des Gegenstandes 3 in Richtung des Pfeiles 7 durch den Messbereich 5 ändern sich Kenngrößen (L,C,R) der Sensorspule 23, insbesondere der jeweiligen Spulensektion 27, 29 unterschiedlich stark, was mittels Sensorelektronik 9 auswertbar ist. Insbesondere ist eine Phasenverschiebung der Schwingkreise 39 und 41 auswertbar, die im Bereich der Resonanzfrequenzen vorteilhaft besonders sensibel ist.

Es ist jedoch auch denkbar, die Schwingkreise 39 und 41 so mit dem Oszillator 15 zu beschalten, dass diese jeweils ungedämpfte Schwingungen ihrer tatsächlichen Resonanzfrequenz durchführen, die sich mit den Kenngrößen der Sensorspule 23, dem zugeordneten Oszillator 15 und damit mit den jeweiligen Kenngrößen der Spulensektionen 27 und 29 (L,C,R) ändern. Da der Gegenstand 3 die Kenngrößen (L,C,R) der Spulensektionen 27, 29 beeinflusst, kann mittels Ermitteln der Frequenzen der Schwingkreise 39 und 41 auf eine Position des Gegenstandes 3 relativ zu den Spulensektionen 27 und 29 geschlossen werden.

Zum Zuführen einer zum Erhalten der elektrischen Schwingungen der Schwingkreise 39 und 41 notwendigen elektrischen Hilfsenergie ist der Sensorelektronik 9 bzw. dem Oszillator 15 der Sensorelektronik 9 eine mittels des Bezugszeichens 45, in Figur 1 nicht näher dargestellte, elektrische Energiequelle 45 zugeordnet. Hierzu sind Leitungen 47 vorgesehen, die zum Bereitstellen der elektrischen Hilfsenergie mittels der Energiequelle 45 und/oder zum Übertragen einer Information bzw. eines Messergebnisses der Sensorvorrichtung 1 ausgelegt sind. Es ist denkbar, dass diese Informationen mittels weiterer nicht näher dargestellter Bauteile der Sensorelektronik 9 generiert werden. Es ist jedoch auch denkbar, dass mittels der Leitungen 47 weitere Auswertebauelemente der Sensorelektronik 9 zugeordnet sind. Mittels der Sensorelektronik 9 kann beispielsweise eine die Bewegung des Gegenstandes 3 kennzeichnende Gleichspannung erzeugt werden.

Figur 2 zeigt ein weiteres Ausführungsbeispiel einer Sensorvorrichtung 1 zum Detektieren eines Gegenstandes 3 und dessen Bewegung in einem Messbereich 5 der Sensorvorrichtung 1. Die Sensorvorrichtung 1 ist bezüglich der Sensorspule 23 identisch aufgebaut wie die Sensorvorrichtung 1 gemäß Figur 1. Insofern wird im Folgenden lediglich auf die Unterschiede eingegangen. Im Unterschied zur Darstellung gemäß Figur 1 ist die Sensorvorrichtung 1 mit einer Sensorelektronik 9 versehen, die nur einen Schwingkreis 49 aufweist, der mittels des Oszillators 15 zu elektrischen Schwingungen anregbar ist. Der Schwingkreis 49 ist als Parallelschwingkreis ausgeführt und kann alternativ oder zusätzlich auch als Reihenschwingkreis ausgeführt sein. Bei dem Oszillator 15 gemäß Figur 2 kann es sich ebenfalls um einen Festfrequenzoszillator oder einem den Schwingkreis 49 mit einer variablen Frequenz anregenden Oszillator handeln. Im Unterschied weist der Schwingkreis 49 der Sensorelektronik 9 nur eine Kapazität 51 auf, der der gesamten Sensorspule 23 zugeordnet bzw. parallel geschaltet ist. In diesem Fall sind die Spulensektionen 27 und 29 in Reihe geschaltet. Die Spulensektionen 27 und 29 sind an einem elektrischen Abgriff C 53 einander zugeordnet. Gemäß der Darstellung in Figur 2 stellt der elektrische Abgriff C 53 einen gedachten Punkt auf der Spulenachse z 31 dar, an dem die erste Spulensektion 27 in die zweite Spulensektion 29 übergeht. Gemäß der Darstellung in Figur 1, ist der elektrische Abgriff C 53 als Mittenkontakt 55 ausgeführt, der eine, durch die Spulenachse z 31 hindurchführende Windung 25 beziehungsweise mittig angeordnete elektrische Leitung der Sensorspule 23 der Sensorelektronik 9 zuordnet. Der Mittenkontakt 55 führt durch eine zentrische Bohrung 57 des Trägers 19 hindurch.

Gemäß der Darstellung in Figur 2, kann die Bohrung 57 entfallen oder alternativ lediglich nicht beschaltet sein. Zur Zuordnung der ersten Spulensektion 27 zur Kapazität 51 weist die erste Spulensektion 27 einen ersten Kontakt A 59 auf. Zur entsprechenden Zuordnung der zweiten Spulensektion 29 weist diese einen zweiten Kontakt B 61 auf. Die Kontakte 59 und 61 stellen jeweils Endpunkte einer die einzelnen Windungen 25 der Sensorspule 23 aufweisenden Gesamtwicklung 63 dar. Die Windungen 25 der Spulensektionen 27 und 29 werden durch einen zwischen den Kontakten 59 und 61 angeordneten und über diese mit einem gemeinsamen Strom bestombaren gemeinsamen Leiter beziehungsweise Leiterbahn gebildet. Der gemeinsame Leiter bildet vorteilhaft eine Gesamtspule mit den drehsymmetrischen Spulensektionen 27 und 29 beziehungsweise einem drehsymmetrischen Paar der Spulensektionen 27, 29.

Gemäß Figur 1 und Figur 2 sind die Kontakte A, B 59 und 61 ebenfall mittels Bohrungen 57 durch den Träger 19 hindurch kontaktierbar. Mittels der Bohrung 57 ist es möglich, die Sensorelektronik 9 auf einer der Trägervorderseite 21 gegenüberliegenden Trägerrückseite 65 des Trägers 19 anzuordnen. Die einzelnen elektronischen Bauteile der Sensorelektronik 9 können ebenfalls als bedruckte Schaltung ausgeführt werden. Es ist jedoch auch denkbar, diese auf der Trägerrückseite 65 zu montieren. Entsprechende Leiterbahnen zur Kontaktierung der Sensorelektronik 9 sind in den Figuren 1 und 2 nicht vollständig erkennbar bzw. lediglich schematisch angedeutet.

Im Unterschied ist gemäß Figur 2 die Sensorvorrichtung 1 als Näherungsschalter ausgelegt, wobei eine Annäherung des Gegenstandes 3, wie in Figur 2 mittels eines Pfeiles 7 angedeutet, sensierbar ist. Dabei ist es möglich, dass mittels der Sensorelektronik 9 bei Unterschreiten eines mittels des Bezugszeichens 71 angedeuteten Schaltabstands ein entsprechendes Messsignal generierbar ist. Die Annäherung kann entlang der Spulenachse z 31

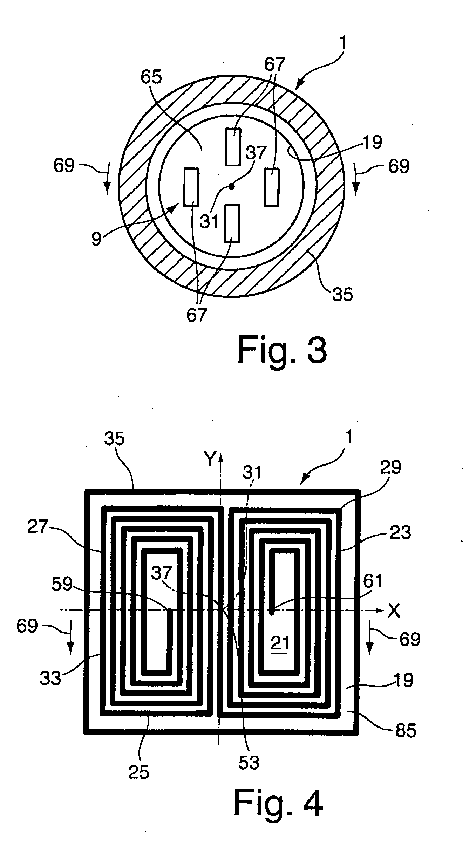

Figur 3 zeigt einen Längsschnitt einer Innenansicht einer weiteren Sensorvorrichtung 1. Es ist zu erkennen, dass eine Sensorelektronik 9 mit verschiedenen elektronischen Bauteilen 67 einen drehsymmetrischen Aufbau bezüglich der Spulenachse z und/oder der Gehäuseachse 37 aufweist. Mittels Pfeilen 69 sind mittels der ersten Spulensektion 27 und der zweiten Spulensektion 29 in dem Gehäuse 35 induzierbare Ringströme angedeutet. Es ist zu erkennen, dass diese entgegengesetzte Richtungen aufweisen. Ferner können diese in ihrem Betrag übereinstimmen, wobei sich vorteilhaft die Ringströme zu Null aufheben. Vorteilhaft übt also das Gehäuse 35 aufgrund des drehsymmetrischen Aufbaus der Spulensektionen 27 und 29 der Sensorspule 23 keinen oder zumindest nur einen minimalen Effekt aus, wobei ein besonders gutes Messergebnis zu erwarten ist.

Figur 4 zeigt ein weiteres Ausführungsbeispiel einer Sensorspule 23, die im Unterschied zur Darstellung gemäß der Figuren 1 und 2, eine erste rechteckige Spulensektion 27 und eine zweite rechteckige Spulensektion 29 aufweist. Das Gehäuse 35 ist ebenfalls rechteckförmig. Die Sensorspule 23 sowie das Gehäuse 35 sind um die Spulenachse z 31 sowie die Gehäuseachse 37 drehsymmetrisch um 180° aufgebaut. Es ist zu erkennen, dass der elektrische Abgriff C 53, der auch einen Flächenschwerpunkt der Gesamtwicklung 63 der Sensorspule 23 darstellt, auf der Spulenachse z 31 sowie der Gehäuseachse 35 liegt.

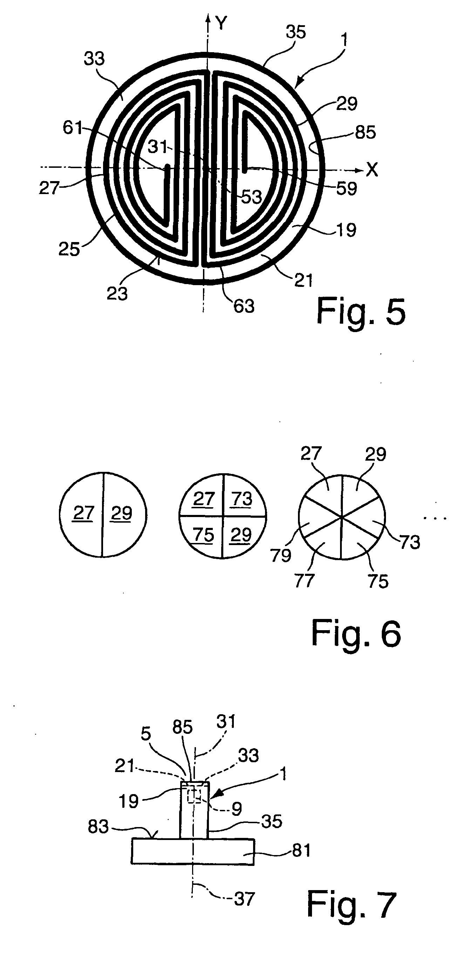

Figur 5 zeigt eine weitere Draufsicht auf eine Sensorspule 23 mit einer ersten Spulensektion 27 und einer zweiten Spulensektion 29, analog der in den Figuren 1 und 2 dargestellten Sensorspule 23. Es ist die Drehsymmetrie um 180° um die Spulenachse z 31 sowie die Gehäuseachse 37 zu erkennen. Die Gesamtwicklung 63 der Sensorspule 23 beginnt am ersten Kontakt 59 und ist von innen heraus mit größeren jeweils zumindest näherungsweise kreissegmentbeziehungsweise kreisabschnittsförmigen Windungen im Uhrzeigersinn bis zum elektrischen Abgriff C 53 aufgebaut. Mit identischem Wickelsinn, ebenfalls im Uhrzeigersinn ist die zweite Spulensektion 29 aufgebaut, deren Wicklung als Teil der Gesamtwicklung 63 am zweiten Kontakt 61 beginnt und ebenfalls mit größer werdenden kreisabschnittsförmigen Windungen 25 im Uhrzeigersinn aufgebaut ist und schließlich ebenfalls am elektrischen Abgriff C 53 endet. Am elektrischen Abgriff C 53 gehen die erste Spulensektion 27 und die zweite Spulensektion 29 elektrisch kontaktiert ineinander über und bilden so die achtförmig gewickelte Gesamtwicklung 63. Ausgehend von der Spulenachse z 31 bzw. des elektrischen Abgriffs C verlaufen die Windungen 25 parallel und sind bei einer Beschaltung mittels des ersten Kontaktes 59 und des zweiten Kontaktes 61 vorteilhaft gegenläufig bestromt.

Figur 6 zeigt schematische Ansichten weiterer Sensorspulen 23, wobei eine links angeordnete Sensorspule 23 zwei Spulensektionen 27, 29 und eine mittig angeordnete Sensorspule insgesamt vier Spulensektionen, eine erste Spulensektion 27, eine zweite Spulensektion 29, eine dritte Spulensektion 73 sowie eine vierte Spulensektion 75 aufweist. Eine rechts angeordnete Sensorspule 23 weist eine erste Spulensektion 27, eine zweite Spulensektion 29, eine dritte Spulensektion 73, eine vierte Spulensektion 75, eine fünfte Spulensektion 77 sowie eine sechste Spulensektion 79 auf. Die Spulensektionen 27, 29 sowie 73 bis 79 sind jeweils drehsymmetrisch zur Spulenachse z 31 angeordnet in einem Winkel von 180°, 90° bzw. 60°. Nicht dargestellte Windungen der in Figur 6 dargestellten Sensorspulen 23 sind analog der in Figur 6 dargestellten Windungen 25 angeordnet, so dass sich ebenfalls der identische Wickelsinn sowie eine gegenläufige Bestrombarkeit der Spulensektionen 27 bis 79 ergibt.

Figur 7 zeigt eine Sensorvorrichtung 1, beispielsweise aufgebaut gemäß den Figuren 1 bis 6, die einer Trägervorrichtung 81 zugeordnet ist. Die Sensorspule 23 sowie die zugeordnete Sensorelektronik 9 sind lediglich schematisch gepunktet angedeutet. Es ist zu erkennen, dass die Sensorvorrichtung 1 bzw. die Spulenachse z 31 sowie die Gehäuse 37 der Sensorvorrichtung 1 senkrecht zu einer Oberfläche 83 der Trägervorrichtung 81 angeordnet sind. Vorteilhaft ergeben sich so ebenfalls ein größtmöglicher symmetrischer Aufbau und eine möglichst geringe Beeinflussung eines Messergebnisses der Sensorvorrichtung 1 durch die Trägervorrichtung 81. Die Trägervorrichtung 81 kann ein eigentlich den Messvorgang der Sensorvorrichtung 1 beeinflussendes elektrisch leitfähiges Material, beispielsweise ein Metall aufweisen. Dank der senkrechten Anordnung ist dieser Einfluss jedoch vorteilhaft minimiert. Das Gehäuse 15 kann vorteilhaft auch nicht abschirmend, beispielsweise einen Kunststoff aufweisend, ausgeführt sein.

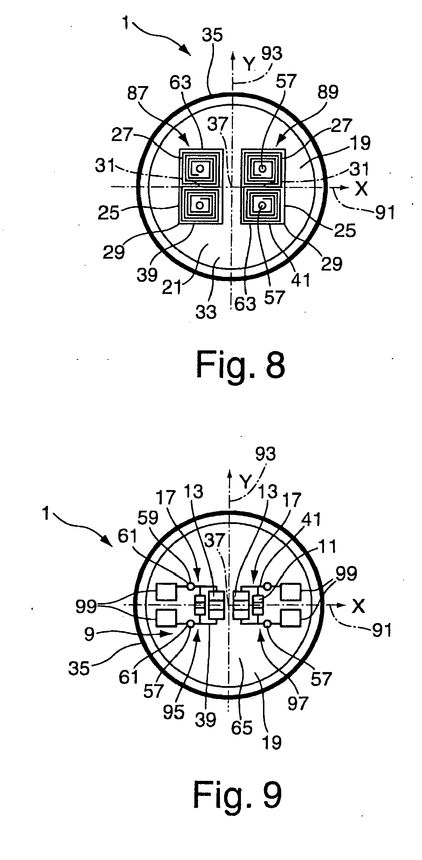

Fig. 8 zeigt eine schematische Außenansicht einer weiteren Sensorvorrichtung 1 mit einer Sensorspule 87 und einer weiteren Sensorspule 89, die analog der in Figur 4 dargestellten Sensorspule 23 aufgebaut sind und von einem zylindrischen Gehäuse 35 umgeben sind. Die in Figur 8 dargestellte Sensorvorrichtung 1 ist analog zu den vorab beschriebenen aufgebaut. Insofern werden lediglich die Unterschiede erläutert.

Im Unterschied sind zwei identisch aufgebaute Sensorspulen 87 und 89 vorgesehen, die jeweils für sich den vorab beschriebenen drehsymmetrischen Aufbau mit zwei Spulensektionen 27 und 29 jeweils zu einer Spulenachse 31 aufweisen. Die Sensorspulen 87 und 89 sind ihrerseits auf dem Träger 19 drehsymmetrisch zu der Gehäuseachse 37 angeordnet. Zur Verdeutlichung von Richtungen sind in Figur 8 eine X-Achse 91 und eine Y-Achse 93 eingezeichnet. Die Gehäuseachse 37 steht senkrecht zu den Achsen 91 und 93 und hat mit diesen einen gemeinsamen Schnittpunkt beziehungsweise fällt mit einer zugehörigen Z-Achse zusammen.

Die jeweiligen Spulensektionen 27 und 29 der Sensorspulen 87 und 89 sind jeweils gegenüberliegend zueinander angeordnet, wobei die X-Achse zwischen diesen liegt und die jeweilige Spulenachse 31 senkrecht zur X-Achse steht und diese schneidet. Die Sensorspulen 87 und 89 sind ebenfalls gegenüberliegend zueinander angeordnet, wobei die Y-Achse 93 zwischen diesen liegt.

Fig. 9 zeigt eine schematische Innenansicht der in Figur 8 gezeigten Sensorvorrichtung 1 auf eine Sensorelektronik 9. Pro Sensorspule 87, 89 weist der Träger 19 zwei Bohrungen 59 auf, durch die hindurch die Kontakte 59 und 61 geführt sind. Mittels der durch die insgesamt vier Bohrungen 57 hindurch geführten Kontakte 59 und 61 sind der Sensorspule 87 eine erste Teilsensorelektronik 95 und der weiteren Sensorspule 89 eine zweite Teilsensorelektronik 97 zugeordnet. Jede Teilsensorelektronik 95, 97 weist eine eigene erste Kapazität 11 und eine parallel geschaltete zweite Kapazität 13 auf, die jeweils der auf der gegenüberliegenden Seite des Trägers 19 angeordneten zugehörigen Sensorspule 87, 89 parallel geschaltet sind. Die erste Teilsensorelektronik 95 und die zugeordnete Sensorspule 87 sowie deren Eigenkapazität bilden den ersten Schwingkreis 39 und die zweite Teilsensorelektronik 97 und die zugeordnete weitere Sensorspule 89 sowie deren Eigenkapazität bilden den zweiten Schwingkreis 41. Im Unterschied sind die Schwingkreise 39 und 41 gänzlich unabhängig voneinander kontaktierbar, weisen also keinen gemeinsamen Mittenkontakt auf. Die Kapazitäten 11 und 13 können die Temperaturkompensation 17 aufweisen und/oder bilden. Dazu können diese unterschiedliche Kapazitätswerte und/oder unterschiedliche Temperaturverhalten aufweisen.

Den Schwingkreisen 39 und 41 sind je zwei Kontaktflächen 99 zugeordnet. Genauer ist jedem der insgesamt vier Kontakten 59 und 61 jeweils eine der Kontaktflächen 99 zugeordnet. Die Teilsensorelektroniken 95 und 97, die Bohrungen 57, die Kontakte 59 und 57 sowie die Kontaktflächen 99 sind drehsymmetrisch zur Gehäuseachse 37 auf dem Träger 19 angeordnet. Insgesamt ist der Träger 19 inklusive aller Bauteile drehsymmetrisch.

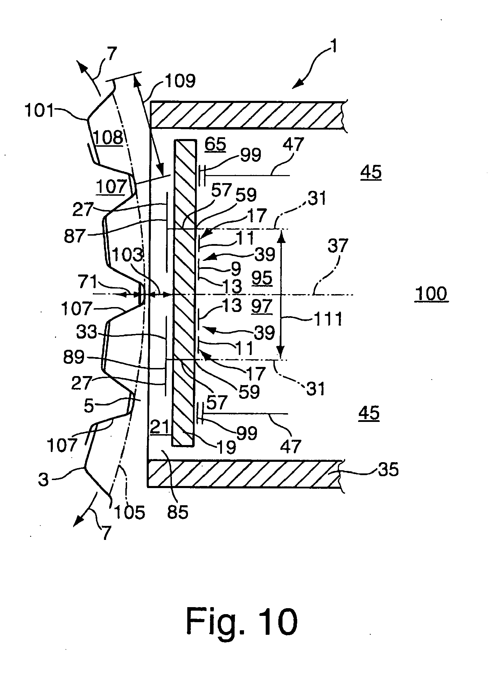

Mittels der Kontaktflächen 99 können die Schwingkreise 39 und 41 einer in Figur 10 mittels des Bezugszeichens 100 angedeuteten Logik zugeordnet werden. Es ist denkbar, dass jedem der Schwingkreise 39 und 41 eine eigene Logik zugeordnet ist.

Fig. 10 zeigt einen Längsschnitt der in den Figuren 8 und 9 dargestellten Sensorvorrichtung zusammen mit einem teilweise dargestellten Zahnrad 101, wobei die X-Achse 91 in einer Schnittebene des Längsschnitts liegt.

Ein Kopfkreis 105 des Zahnrads 101 ist in einem Abstand 103 zu der Spulenebene 33 der Sensorspulen 87 und 89 angeordnet.

Vorteilhaft beträgt der Abstand 103 ungefähr die Hälfte eines maximalen Schaltabstands beziehungsweise des Schaltabstands 71 der Sensorvorrichtung 1. Vorteilhaft tauchen also Zähne 107 des Zahnrads 101 in einen Messbereich der Sensorvorrichtung 1 ein beziehungsweise unterschreiten den Schaltabstand 71 im Lauf einer Drehung des Zahnrads 101 um ungefähr 50% und überschreiten diesen dann wieder. Vorteilhaft können so sich vorbeidrehende Zähne 107 von dazwischen liegenden Zahnlücken 108 des Zahnrads 101 unterschieden werden.

Das Zahnrad 101 weist ein Modul m und eine Teilung beziehungsweise einen Zahnabstand p 109 auf, wobei sich das Modul m als Quotient des Zahnabstands 109 durch die Kreiszahl Pi ergibt. Vorteilhaft kann ein Abstand 111 der Spulenachsen 31 der Sensorspulen 87 und 89 auf das Modul m des Zahnrades 101 und/oder den Zahnabstand p 109 des Zahnrades angepasst sein. Der Abstand 111 der Sensorspulen 87 und 89 beziehungsweise der zugehörigen Spulenachsen 31 kann beispielsweise ein Vielfaches des Zahnabstands p 109 betragen. Als Faktor kommt beispielsweise ein Wert von cirka 0,25 + n*0,5 in Frage, mit n = 0, 1, 2, 3 .... Dabei ergibt sich für zwei schwingende oder schaltende Signale, die mittels den Schwingkreisen 39 und 41 sowie den Teilsensorelektroniken 95 und 97 und/oder weiteren nicht näher dargestellten elektronischen Bauelementen ermittelbar sind, eine Phasenverschiebung von ungefähr Pi/2.

Dies kann vorteilhaft für eine Bestimmung einer Drehrichtung des Zahnrads 101 ausgenutzt werden. Eine entsprechende Auswertung kann beispielsweise mittels der Logik 100 erfolgen. Je nach Auslegung der Logik 100 ist es denkbar, lediglich die Drehrichtung auszuwerten oder bereits kleinste Winkeländerungen des Zahnrads 101 zu messen und/oder deren Richtung zu bestimmen.

Die Logik 100 kann vorteilhaft mittels der Kontaktflächen 99 und/oder der in Figur 10 schematisch angedeuteten Leitungen 47 kontaktiert werden. Die Logik 100 kann Teil einer die Teilsensorelektroniken 95 und 97 aufweisenden Gesamtsensorelektronik 9 der Sensorvorrichtung 1 oder der Sensorvorrichtung 1 nachgeschaltet sein.

Mittels der in den Figuren 8 bis 10 dargestellten Sensorvorrichtung 1 kann das Zahnrad 101 abgetastet werden. Die zwei drehsymmetrischen Sensorspulen 87 und 89 sind in dem Abstand 111 zueinander angeordnet, der auf das Modul beziehungsweise den Zahnabstand p 109 des Zahnrades 101 angepasst ist. Mittels dieser Anpassung und der darauf abgestimmten oder abstimmbaren Logik 100 kann eine Vorwärts-Rückwärts-Erkennung durchgeführt werden. Vorteilhaft können die Sensorspulen 87 und 89 so versetzt sein, dass sich eine Phasenverschiebung um, insbesondere ungefähr, Pi/2 ergibt. Das Zahnrad 101 und die Sensorvorrichtung 1 sind so relativ zueinander angeordnet, dass der Kopfkreis 105 des Zahnrads 101 die Gehäuseachse 37, insbesondere ungefähr, senkrecht schneidet und dass sich an einem Schnittpunkt des Kopfkreises 105 mit der Gehäuseachse 37 die Zähne 107, je nach Drehrichtung, insbesondere ungefähr, in Richtung oder entgegen der X-Achse 91 bewegen.

Vorteilhaft kann mittels der in Figur 1 dargestellten Sensorvorrichtung 1 auch eine Drehrichtungserkennung erfolgen. Die gezeigten Sensorvorrichtungen 1 können als Allmetallschalter betrieben werden. Die in Figur 2 gezeigte Sensorvorrichtung 1 kann beispielsweise so geschaltet werden, dass mittels Abfragen einer Differenzfrequenz eine Annäherung des Gegenstandes 3 ermittelbar ist. Hierzu kann beispielsweise eine Grundfrequenz von 50 kHz verwendet werden, insbesondere additiv. Es ist denkbar, die Sensorvorrichtung 1 als Distanzsensor, Positionssensor und/oder Drehratensensor zu verwenden bzw. zu beschalten. Vorteilhaft treten aufgrund des flächigen Aufbaus der Sensorspule 23 sehr geringe Temperatureinflüsse auf. Um diese zusätzlich zu eliminieren, kann die Temperaturkompensation 17 alternativ vorgesehen sein. Vorteilhaft ist auch ein Abgleich der Sensorvorrichtung 1 deutlich einfacher, insbesondere ergibt sich ein geringerer Einfluss aufgrund von Ungenauigkeiten beim Einbau in das Gehäuse 35.

Das Gehäuse 35 weist eine in Richtung des zu detektierenden Gegenstandes 3 gerichtete Gehäuseöffnung 85 auf. Alternativ und/oder zusätzlich ist es denkbar, die Gehäuseöffnung 85 mit einem Schutz zu versehen, beispielsweise ein nicht elektrisch leitfähiges sowie ein magnetisches Wechselfeld möglichst geringfügig beeinflussendes Material. Durch die Gehäuseöffnung 85 hindurch findet die Messung der Sensorvorrichtung 1 statt.

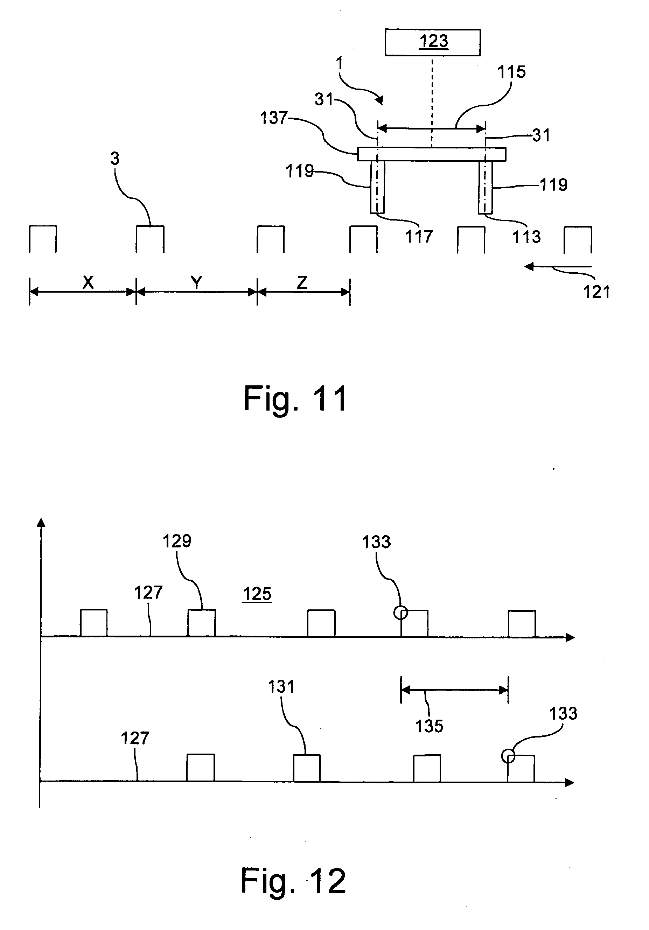

Figur 11 zeigt eine schematische Ansicht einer Sensorvorrichtung 1 mit einer Sensorspule 113 und einer in einem Abstand 115 daneben angeordneten zusätzlichen Sensorspule 117. Jede der Sensorspulen 113, 117 weist ein Gehäuse 119 und eine nicht näher dargestellte Sensorelektronik auf. Bezüglich des Aufbaus und/oder der Bestromung der Sensorspulen 113, 117 wird auf die Beschreibung der Figuren 1 bis 10 verwiesen. Spulenachsen 31 weisen den Abstand 115 auf und sind parallel zueinander angeordnet. Alternativ ist es denkbar, dass die Spulenachsen 31 in einem Winkel zueinander angeordnet sind, sich insbesondere schneiden. In diesem Fall kann unter dem Abstand 111 ein Abstand von Durchstoßpunkten, an denen die Spulenachsen 31 die Sensorspulen 113, 117 beziehungsweise deren Träger 19 durchstoßen verstanden werden. An den Sensorspulen wird eine Vielzahl von Gegenständen 3 mit einer Relativgeschwindigkeit vorbeibewegt. Die Relativgeschwindigkeit ist in Figur 11 mittels eines Pfeils 121 angedeutet.

Die Gegenstände 3 weisen unterschiedliche Abstände auf, die in Figur 11 mittels Doppelpfeilen X, Y, Z symbolisiert sind.

Mittels einer den Sensorspulen 113, 117 zugeordneten Auswerteeinheit 123 können die Signale der Sensorspulen 113, 117 ausgewertet und/oder verarbeitet werden, insbesondere um die Relativgeschwindigkeit und/oder die Abstände X, Y, Z zu ermitteln.

Figur 12 zeigt ein Schaubild 125 von zwei Sensorsignalen der in Fig. 11 gezeigten Sensorspulen 113,117 über einer gemeinsamen Zeitachse 127.

In Figur 12 oben ist ein erster Graph 129 eines Verlaufs eines Sensorsignals der Sensorspule 113 und unten ein zweiter Graph 131 eines Verlaufs eines Sensorsignals der zusätzlichen Sensorspule 117 über der Zeitachse 127 dargestellt.

Mittels der Auswerteeinheit kann eine in Figur 12 mittels Kreisen gekennzeichnete Charakteristik 133 der Sensorsignale ermittelt werden, beispielsweise wie in Figur 12 gezeigt eine Signalflanke. Durch einen Vergleich der Verläufe kann die Charakteristik 133 einem der Gegenstände 3 zugeordnet werden.

Aus einer zeitlichen Verzögerung 135 der erkannten Charakteristik 133 kann in Abhängigkeit des Abstands 111 die Relativgeschwindigkeit ermittelt werden. Bei bekannter Relativgeschwindigkeit kann aus einem der Verläufe eine Kontur oder können wie in Figur 11 dargestellt die Abstände X, Y, Z der Gegenstände 3 ermittelt werden. Es ist zu erkennen, dass die Verläufe des Schaubilds 125 - abhängig von einem Maßstab der Zeitachse 127 - die Kontur und/oder die Abstände X; Y; Z abbilden.

Die Gehäuse 119 der Sensorspulen 113, 119 sind einer gemeinsamen Trägerplatte 137 zugeordnet.

Merkmale unterschiedlicher Ausführungsbeispiele können zu neuen Ausführungsbeispielen kombiniert werden. Insbesondere können beliebige Gehäuseformen und Sensorspulenformen miteinander kombiniert werden.

## Patentansprüche

1. Sensorvorrichtung (1) zum Detektieren eines Gegenstandes (3) und dessen Bewegung in einem Messbereich (5) der Sensorvorrichtung (1), aufweisend
- ein um eine Gehäuseachse (37) drehsymmetrisches oder einen polygonförmigen Querschnitt aufweisendes Gehäuse (35) mit einer koaxial zur Gehäuseachse (37) angeordneten Gehäuseöffnung (85),
- eine Sensorspule (23;87), die auf einer Vorderseite (21) eines isolierenden ebenen Trägers (19) aufgebracht und als Flachspule in einer Spulenebene (33) ausgebildet ist, wobei die Sensorspule (23;87) eine Anzahl n = 2 + i*2, mit i = 0, 1, 2,... drehsymmetrisch um eine zur Spulenebene senkrechte Spulenachse z (31) angeordnete, sich nicht überlappende Spulensektionen (27,29;27,29,73,75; 27,29,73,75,77,79) aufweist, die eine identische Windungszahl und einen identischen Wickelsinn besitzen, und der Träger (19) mit der Sensorspule (23) derart in die Gehäuseöffnung (85) eingebracht ist, dass die Trägervorderseite (21) und damit die Sensorspule (23;87) in der Gehäuseöffnung (85) gehäuseoberflächennah angeordnet ist,
- eine mit der Sensorspule (23;87) elektrisch verbundene Sensorelektronik (9), und
- eine mit der Sensorelektronik (9) verbindbare elektrische Energiequelle (45),
wobei mittels der Sensorspule (23;87) ein magnetisches Wechselfeld erzeugbar ist, welches mit im Messbereich (5) der Sensorvorrichtung (1) befindlichen oder sich bewegenden Gegenständen (3) wechselwirkt und aufgrund der Wechselwirkung Änderungen von Kenngrößen (L, C, R) der Sensorspule (23;87) bewirkt, die mittels der Sensorelektronik (9) detektierbar sind.

2. Sensorvorrichtung gemäß Anspruch 1,
**dadurch gekennzeichnet,**
**dass** die Sensorelektronik (9) axial zur Spulenachse z (31) und/oder auf einer der Trägervorderseite (21) gegenüberliegenden Trägerrückseite (65) angeordnet ist, wobei die Anordnung der die Sensorelektronik (9) umfassenden Bauteile (67) auf der Trägerrückseite (65) drehsymmetrisch zur Spulenachse z (31) ist.

3. Sensorvorrichtung gemäß Anspruch 1 oder 2,
**dadurch gekennzeichnet,**
**dass** Enden der Sensorspule (23;87) mit der Sensorelektronik (9) durch drehsymmetrisch zur Spulenachse z (31) angeordnete Bohrungen (57) im Träger (19) kontaktiert sind.

4. Sensorvorrichtung gemäß einem der Ansprüche 1 bis 3,
**dadurch gekennzeichnet,**
**dass** der Träger (19) aus Kunststoff oder Keramik besteht und eine geringe Dicke, insbesondere 0,01 bis 5 mm, insbesondere 0,05 bis 2 mm, insbesondere 0,1 bis 0,9 mm, aufweist.

5. Sensorvorrichtung gemäß einem der Ansprüche 1 bis 4,
**dadurch gekennzeichnet,**
**dass** die Sensorspule (23;87) 2, 4 oder 6 drehsymmetrische Spulensektionen (27,29;27,29,73,75; 27,29,73,75,77,79) aufweist, die Paare bilden, wobei jedes Paar zwei Kontakte (59,61) und einen mittels den Kontakten (59,61) bestombaren gemeinsamen Leiter aufweist.

6. Sensorvorrichtung gemäß einem der Ansprüche 1 bis 5,
**dadurch gekennzeichnet,**
**dass** im Fall von zwei Spulensektionen (27,29)im drehsymmetrischen Mittelpunkt der Sensorspule ein elektrischer Abgriff C (53) vorgesehen ist.

7. Sensorvorrichtung gemäß einem der Ansprüche 1 bis 6,
**dadurch gekennzeichnet,**
**dass** die Sensorelektronik (9) zumindest ein Element der folgenden Gruppe aufweist:
- eine oder mehrere Kapazitäten (11,13;51), die an den Enden (A, B) der Sensorspule (23;87) angeschlossen sind und die mit einer Eigenkapazität der Sensorspule (23;87) einen Schwingkreis (39,41;49) bilden;
- einen Oszillator (15), wobei der Schwingkreis (39,41;49) Bestandteil des Oszillators (15) ist, und der Oszillator (15) mit einer Frequenz betreibbar ist, die der Eigenfrequenz des Schwingkreises (39,41;49) entspricht;
- einen Festfrequenz-Oszillator (15), wobei der Schwingkreis (39,41;49) von dem Festfrequenz-Oszillator (15) fremd erregbar ist, und die Frequenz des Festfrequenz-Oszillators (15) mit der Eigenfrequenz des Schwingkreises (39,41;49) solange identisch ist, solange sich im Messbereich (5) der Sensorvorrichtung (1) kein Gegenstand (3) befindet;
- an den Enden (A, B) und am Abgriff C (53) der Sensorspule (23;87) jeweils angeschlossene, eine oder mehrere Kapazitäten (11,13;51), die mit den Eigenkapazitäten der jeweiligen Spulensektionen (27,29;27,29,73,75; 27,29,73,75,77,79) jeweils einen Schwingkreis (39,41;49) bilden;
- einen Festfrequenz-Oszillator (15), wobei jeder Schwingkreis (39,41;49) von dem Festfrequenz-Oszillator (15) fremd erregbar ist, und die Frequenz des Festfrequenz-Oszillators (15) mit den untereinander übereinstimmenden Eigenfrequenzen der Schwingkreise (39,41;49) solange identisch ist, solange sich im Messbereich (5) der Sensorvorrichtung (1) kein Gegenstand (3) befindet;
- eine Temperaturkompensation (17) mittels zwei oder mehr Kapazitäten (11,13) mit einem unterschiedlichen Temperaturverhalten.

8. Sensorvorrichtung gemäß einem der Ansprüche 1 bis 7,
**dadurch gekennzeichnet,**
**dass** das Gehäuse (35) einen rechteckigen Querschnitt aufweist.

9. Sensorvorrichtung gemäß einem der Ansprüche 1 bis 8,
**dadurch gekennzeichnet,**
**dass** der Träger (19) mit der Sensorspule (23) derart in die Gehäuseöffnung (85) eingebracht ist, dass die Gehäuseachse (37) und die Spulenachse z (31) zusammenfallen.

10. Sensorvorrichtung gemäß einem der Ansprüche 1 bis 9,
**dadurch gekennzeichnet,**
**dass** die Sensorspule (87) und eine weitere identisch aufgebaute Sensorspule (89) vorgesehen sind, die zusammen drehsymmetrisch zur Gehäuseachse (37) angeordnet sind.

11. Sensorvorrichtung gemäß dem vorhergehenden Anspruch,
**dadurch gekennzeichnet,**
**dass** der Gegenstand (3) ein Zahnrad (101) mit einem Zahnabstand (109) aufweist, wobei die Spulenachsen z (31) der Sensorspulen (87,89) einen Abstand (111) aufweisen, der ungefähr das (0,25 + n*0,5)-fache des Zahnabstands (109) mit n = 0, 1, 2, 3 ... beträgt.

12. Sensorvorrichtung gemäß einem der vorhergehenden Ansprüche,
**dadurch gekennzeichnet,**
**dass** beabstandet zu der in dem Gehäuse (119) angeordneten Sensorspule (113) eine in einem zusätzlichen Gehäuse (119) angeordnete zusätzliche Sensorspule (117) angeordnet ist,
wobei die zusätzliche Sensorspule (117) und das zusätzliche Gehäuse (119) Merkmale nach einem der vorhergehenden Ansprüche aufweisen.

13. Sensorvorrichtung gemäß einem der vorhergehenden Ansprüche,
**dadurch gekennzeichnet,**
**dass** den Sensorspulen (113,117) eine Auswerteeinheit nachgeschaltet ist, mittels der ein erstes Sensorsignal der Sensorspule (113) und ein weiteres Signal der zusätzlichen Sensorspule (117) vergleichbar und/oder auswertbar sind.

14. Verfahren zum Detektieren eines Gegenstandes (3) und dessen Bewegung in einem Messbereich (5) einer Sensorvorrichtung (1), insbesondere einer Sensorvorrichtung (1) nach einem der vorhergehenden Ansprüche, mit einer Sensorspule (113), die eine Anzahl n = 2 + i*2, mit i = 0, 1, 2, ... auf einer zu einer Spulenachse z senkrechten Spulenebene paarweise gegenüberliegend oder drehsymmetrisch zur Spulenachse z (31) angeordnete, sich nicht überlappende Spulensektionen (27,29;27,29,73,75; 27,29,73,75,77,79) aufweist, und mit einer in einem Abstand zu der Sensorspule angeordneten zusätzlichen Sensorspule (117), die eine Anzahl n = 2 + i*2, mit i = 0, 1, 2,... auf einer zu einer Spulenachse z (31) senkrechten Spulenebene paarweise gegenüberliegend oder drehsymmetrisch zur Spulenachse z angeordnete, sich nicht überlappende Spulensektionen (27,29;27,29,73,75; 27,29,73,75,77,79) aufweist, mit:
- Jeweils paarweise gegensinniges Bestromen der Spulensektionen der Sensorspule (113) und der zusätzlichen Sensorspule (117),
- Detektieren von Änderungen von Kenngrößen (L, C, R) der Sensorspule (113) und der weiteren Sensorspule (117) mittels einer den Sensorspulen zugeordneten Auswerteeinheit (123).

15. Verfahren nach dem vorhergehenden Anspruch, mit:
- Bewegen des Gegenstands (3) oder eine Vielzahl der Gegenstände (3) mit einer Relativgeschwindigkeit relativ zu der Sensorvorrichtung (1),
- Ermitteln eines Verlaufs oder einer Charakteristik (133) der detektierten Änderungen von Kenngrößen (L, C, R) der Sensorspule (113),
- Ermitteln eines Verlaufs oder einer Charakteristik der detektierten Änderungen von Kenngrößen (L, C, R) der weiteren Sensorspule (117),
- Zuordnen des Verlaufs oder der Charakteristik der Sensorspule zu dem Verlauf oder der Charakteristik (133) der weiteren Sensorspule (117),
- Ermitteln eines Zeitversatzes (135) zwischen den Verläufen oder den Charakteristiken (133),
- Ermitteln der Relativgeschwindigkeit mittels des Zeitversatzes (135) und des Abstands der Sensorspulen,
- Ermitteln einer Kontur des Gegenstands (3) oder eines Abstands (X;Y;Z) einzelner Gegenstände (3) der Vielzahl der Gegenstände (3) aus dem Zeitversatz (135) und der Relativgeschwindigkeit.
